# EUROPEAN PATENT APPLICATION

(11) **EP 2 302 346 A1**
(43) Date of publication of application: **30.03.2011**
(21) Application number: 10181260.0
(22) Date of filing: 28.09.2010
(51) Int. Cl.: G01M 15/02

(54) **Dynamic test bench for development and trial of endothermic and electric motors, particularly for simulation of road traction**

(30) Priority: 29.09.2009 IT MI20091672
(71) Applicant: Mariani, Giovanni, 20144 Milano (IT)
(72) Inventor: Mariani, Giovanni, 20144 Milano (IT)
(74) Representative: Fisauli, Beatrice A. M.

(57) **Abstract**

The present invention concerns a dynamic test bench for measuring the torque and number of revolutions of endothermic engines, both Otto cycle and diesel, and electric motors, for recording the performance and simulating the dynamics of motion of vehicles on the road (inertia, aerodynamic friction and rolling resistance) by the application of suitable motor and braking torques to the shaft of the engine/motor being tested.

The dynamic test bench according to the invention is of the type that provides for the use of an electric machine as motor and braking torque generator, the shaft of said endothermic engine or electric motor being linked to the rotor of said electric machine with means designed to transmit motor and braking torque from said endothermic engine or electric motor to said rotor of said electric machine and vice versa and is characterized in that said means designed to transmit motor and braking torque from said endothermic engine or electric motor (2) to said rotor (10, 21) of said electric machine (3, 20) and vice versa, comprise a rigid linkage between said motor shaft (6) and said rotor (10, 21), the case (8, 22) of said electric machine (3, 20) being rigidly linked to the structure (4) of said endothermic engine or electric motor (2).

## Description

The present invention concerns a dynamic test bench for measuring the torque and number of revolutions of endothermic engines, both Otto cycle and diesel, and electric motors, for recording the performance and simulating the dynamics of motion of vehicles on the road (inertia, aerodynamic friction and rolling resistance) by the application of suitable motor and braking torques to the shaft of the engine/motor being tested.

Test benches of this type are normally used in laboratories for recording performance and measuring polluting emissions, and in research into and development of internal combustion engines and propulsion systems with alternative fuels. The use of said test benches also extends to alternative propulsion systems, such as propulsion with electric motors.

A test bench is a piece of equipment able to absorb the mechanical energy produced by the engine/motor being tested, said absorption occurring according to procedures which must simulate as far as possible the various situations of use of the engine/motor.

Engine/motor test benches are continuously evolving, both because the performance of the engines/motors to be tested has significantly improved and because the tests to be performed are increasingly complex. For example, the laws on emissions, on consumption and on noise require increasingly efficient instruments, at both the design and testing stages.

The introduction of dynamic test benches, due to their ability to simulate the dynamics of motion of the vehicle on the road, has allowed transfer to the laboratory of a large number of tests and trials which until a short time ago were possible only on the road, with considerable advantages in terms of both measurement accuracy and reduction in times and costs. Obviously, therefore, evolution of the test benches increasingly consolidates this trend.

In the dynamic test bench, the characteristics of the vehicle are simulated by connecting the engine/motor being tested to a system able to brake and/or drive the engine/motor, simulating as faithfully as possible the real operating conditions.

In practice the effects of friction, inertia, vehicle mass and air resistance are simulated by subjecting the engine/motor to a torque which, as required, brakes or accelerates the engine/motor. Obviously very rapid response times allow more correct simulation of the characteristics of a complete vehicle.

The most advanced test benches are therefore defined "dynamic" due to their ability to apply to the engine/motor both braking and accelerating torques in order to simulate particular effects due to the mass of the vehicle in movement, for example the braking effect of the engine/motor when the accelerator is released, especially if a lower gear is simultaneously engaged.

A fundamental characteristic of dynamic test benches is their prompt response which allows the simulation of very rapid transient phenomena such as those that occur in engagement and disengagement of the clutch during gear changes, in particular for the simulation of drive patterns. This characteristic is particularly interesting in the case of racing simulation.

The brake used in a dynamic test bench is normally an alternating or direct current electric machine used, according to requirements, as a motor or generator, to apply the respective motor or braking torques to the engine/motor being tested. The mechanical energy of the engine/motor being tested is transformed into electrical energy which is returned to the grid by means of an appropriate converter.

The main characteristics of a dynamic test bench are high rapidity of response, low inertia and the possibility of operating at high rotation speeds. The aspects concerning connection to the grid are also important; a high power factor and low harmonic distortion are required.

The electric machine that acts as a generator and motor is normally an asynchronous machine. This solution provides a low moment of inertia of the rotor, reduced overall dimensions and low noise level.

Embodiments are known which use synchronous machines, since they offer advantages in terms of reduction in response times and reduction in overall dimensions.

The connection between the engine/motor and the electric machine (asynchronous or synchronous) is normally made by means of mechanical joints. Due to imperfect alignment of the shafts of the two machines, arising from inevitable machining imperfections, universal joints or flexible couplings must be used, and this entails two serious drawbacks, one of a technical nature and one of an economic nature.

A first drawback, of technical type, consists in the fact that torsional vibration occurs due to the elasticity of the coupling. Variations in amplitude and/or resonance are created which require a very accurate study of the coupling, in order not to introduce excessive insertion errors, not acceptable with the precisions required by the latest generation engines/motors. Special algorithms are used to correct the measurement error since, with engine/motor-generator systems, said errors can be compensated for within the single revolution. Nevertheless, in particular at the lowest rotation speeds, it is practically impossible to eliminate the resonance, which can lead to breakage of the connection elements and, in some cases, even breakage of the drive shaft.

A second drawback, of economic type, consists in the fact that preparation of the test equipment is excessively laborious. This is a very penalising factor in the case of short tests, in which preparation can require longer than the test itself.

Synchronous machines also have some problems, since the permanent magnets, which are on the rotor, limit the rotation speed due to their mass. Said magnets are very heavy and tend to become dislodged from their seat due to the particularly strong centrifugal force.

The present invention solves the above problems via the use of a device according to claim 1. The invention consists in a dynamic test bench, for the development and trial of endothermic engines and electric motors, of the type that uses an electric machine as a motor and braking torque generator for application to the engine/motor being tested, characterised in that the rotor and the case of said electric machine are rigidly linked to the shaft and the structure respectively of said engine/motor being tested, the stator of said electric machine being supported by said case and being free to rotate with respect to it.

In practice the rotor of the electric machine is disengaged from the stator of the machine, therefore it can be made integral with the shaft of the engine/motor being tested. The defects in alignment between the geometric axes of the two machines are of no consequence as they are absorbed by the clearance existing between stator and rotor in the electric machine. The stator of the electric machine is mounted free to rotate on its axis, but rotation is effectively prevented since a torque transducer is inserted between stator and case for measurement of the torque.

It should be noted that this operation is possible due to the fact that the misalignments are very slight, since the inaccuracies are contained within the machining tolerances.

According to a preferred embodiment of the invention, the electric machine is a synchronous machine characterised by a configuration suitable for annulling the effect of the centrifugal force, as regards the effects on the permanent magnets. In said configuration the rotor, with the permanent magnets, is external to the stator. In this way said rotor can assume the form of a robust ring, or drum, inside which the permanent magnets are housed. Due to this configuration, the centrifugal force tends to push the magnets against the supporting structure, instead of separating them from the structure.

The use of a device according to the invention therefore overcomes the drawbacks of the prior art. In particular, preparation of the test is considerably speeded up, due to direct connection of the rotor of the electric machine with the shaft of the engine/motor being tested, while elimination of the couplings eliminates at the root all the drawbacks connected with the elasticity thereof. Overcoming of the drawbacks due to the limited rotation speed also means that the advantages of use of the synchronous machine can be extended to all the rotation speeds of the engine/motor to be tested.

The invention will now be described, for illustrative non-limiting purposes, according to a preferred embodiment and with reference to the accompanying figures in which:
- figure 1 shows an engine/motor being tested connected to a synchronous electric machine;
- figure 2 shows an engine/motor being tested connected to an asynchronous electric machine.

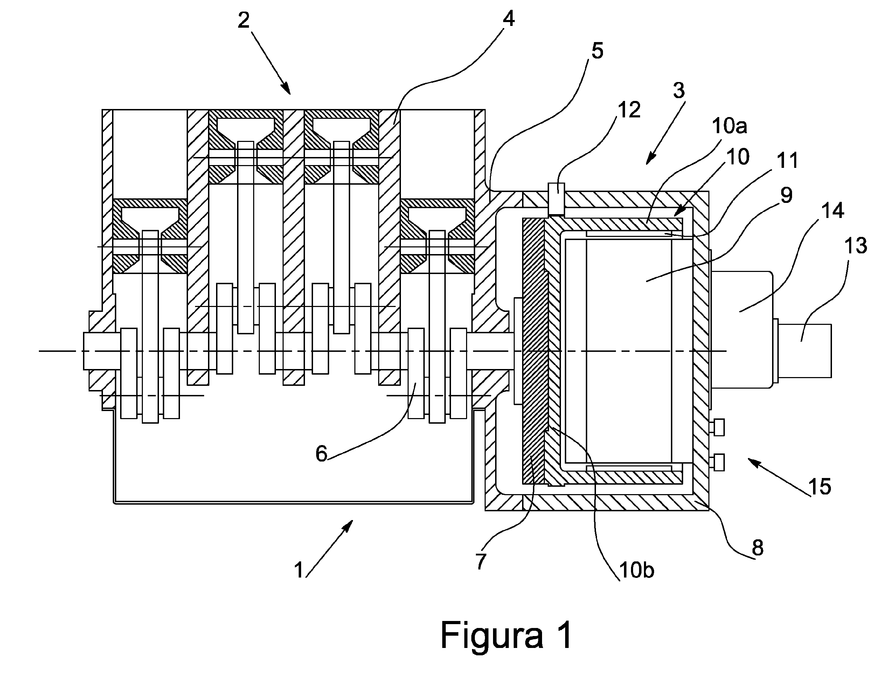

With reference to fig. 1, (1) indicates the unit consisting of an engine/motor (2) and a synchronous electric machine (3). Said unit (1), fitted on a supporting structure (not shown), constitutes the dynamic test bench according to the invention.

The engine/motor (2) comprises a structure, or monobloc (4), provided with appropriate threaded holes and centring pins (5) for connection to the transmission system and a crank shaft (6), or drive shaft, on which a flywheel (7) is fitted.

The engine shown is an endothermic piston engine and the following description will refer to it, in particular as regards the elements for connection to the electric machine. In fact, the structure of endothermic engines for road use is normally provided, on the power outlet side, with said threaded holes and centring pins (5) which are used for assembly of the transmission system. The structure of electric motors is also normally provided with a connection flange which, in the case of road use, is used for connecting the motor to the transmission system. Furthermore the electric motor does not normally entail the use of said flywheel (7) which, as will be seen below, is also used for connection to the electric machine.

In turn the synchronous electric machine (3) comprises a structure (8), which constitutes the case of said synchronous machine (3) and which acts as a support for the stator (9), which is free to rotate around its axis. Said synchronous electric machine (3) also comprises a rotor (10), on which permanent magnets (11) are fitted.

According to a preferred embodiment, the rotor (10) has the form of a ring, or drum, (10a) integral with a disc (10b), said drum (10a) and said disc (10b) being coaxial with each other and with the stator (9). The permanent magnets (11) are fitted inside the drum (10a) of the rotor (10) and are obviously interfaced to the stator (9) with an appropriate air gap.

Notwithstanding the fact that the rotor (10) must comprise a ferromagnetic ring, it can be advantageously produced partly with very lightweight and resistant materials, such as composite materials, for example carbon fibre based, or titanium and aluminium alloys. In this way the rotating masses are significantly reduced, consequently widening the field of application of the synchronous machine (3) towards less powerful engines/motors and/or engines/motors with higher rotation speed.

The rotor (10) is mounted on the flywheel (7) of the engine/motor (2), then the case (8), with the stator (9) of the synchronous machine (3), is mounted on the monobloc (4) using the fixing holes and the dowels (5) provided on said monobloc (4).

Any connection of the rotor (10) to the shaft of an electric motor, which is normally not provided with flywheel, may be made without any particular problems, by keying the disc (10b) of the rotor (10) directly on the shaft of the electric motor.

Assembly is performed observing the coaxiality between the crank shaft (6) of the engine/motor (2) and the rotor (10) and stator (9) of the synchronous machine (3).

The test device is completed by a high resolution encoder (12), an electric power outlet (13) and a torque transducer (14). A liquid cooling system (15) for removing the heat generated during operation is also provided.

The torque transducer (14) is mounted between the case (8) and the stator (9), effectively blocking the reciprocal rotation, barring a very small quantity which corresponds to deformation of the loading cell of said torque transducer (14).

In the test device the unit consisting of the flywheel (7) and rotor (10) shall have a mass and moments of inertia which can be calculated with algorithms of known type, such as to best simulate the real operating conditions of the engine/motor (2).

The test device is operated by connecting the encoder (12) and the torque transducer (14) to an instrument of known type (not shown) using known techniques.

An alternative to the operation described consists in connecting the encoder (12) and the electric power outlet (13) to an instrument of known type (not shown) using known techniques. In this case the torque transducer (14) is not required and therefore the stator (9) can be rigidly linked to the case (8) of the synchronous machine (3).

As appears clear from the preceding description, assembly of the test device is very simple and rapid, as only the rotor (10) has to be mounted on the flywheel (7) and the case (8), en bloc with the stator (9), on the threaded holes and the fastening pins (5) of the monobloc (4), without having to pay any particular attention to the alignment. Furthermore the absence of a coupling eliminates at the root all problems connected with the dynamic responses of the coupling. Furthermore the special configuration of the synchronous machine (3) allows effective countering of the centrifugal force acting on the magnets (11), brilliantly overcoming the limitations of use of the synchronous machines of the known art.

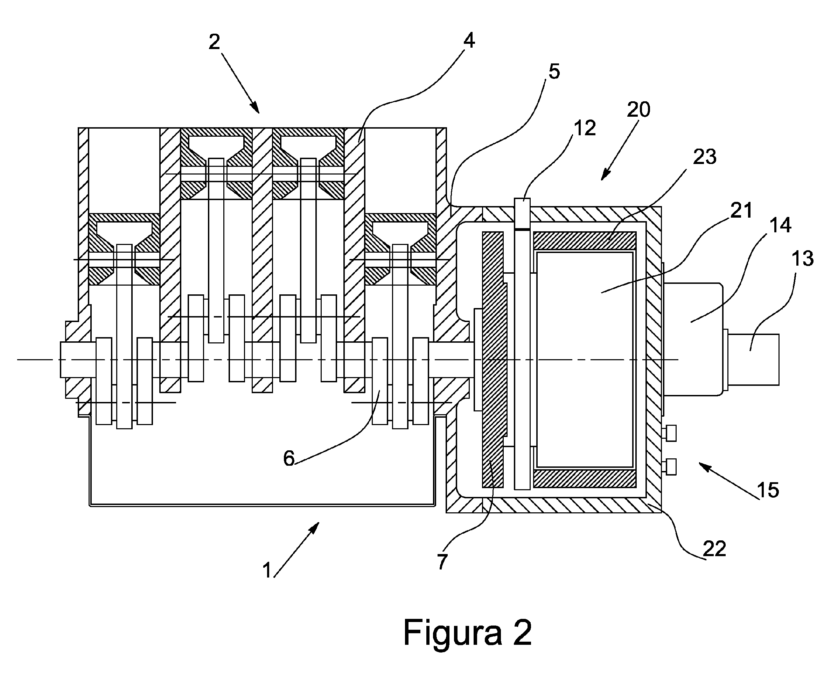

The type of assembly described lends itself to use also with an asynchronous machine (20), of the type normally used in dynamic test benches of the known art, as shown in fig. 2. Since the rotor (21) of an asynchronous machine does not have any particular problems in relation to the high rotation speeds, said rotor (21) of said asynchronous machine (20) may remain in its normal position. Here again, the case (22) of the asynchronous machine, which acts as a support for the stator (23), will be rigidly linked to the structure (4) of the engine/motor (2) using the fastening holes and datum-pins (5) provided on the monobloc (4).

The device comprising an asynchronous machine (20) is operated also in this case using the torque transducer (14) or the electric power outlet (13).

If an asynchronous machine (20) is used, the advantages of use of a synchronous machine (3) will obviously not apply, but the important advantages connected with elimination of the coupling will nevertheless remain.

The invention has been described, for illustrative non-limiting purposes, according to a preferred embodiment and a variation thereof. A person skilled in the art may find numerous other embodiments, all falling within the protective scope of the following claims.

## Claims

1. Dynamic test bench, for development and trial of endothermic engines and electric motors, of the type that provides for the use of an electric machine as motor and braking torque generator, the shaft of said endothermic engine or electric motor being linked to the rotor of said electric machine with means designed to transmit motor and braking torque from said endothermic engine or electric motor to said rotor of said electric machine and vice versa, **characterized in that** said means designed to transmit motor and braking torque from said endothermic engine or electric motor (2) to said rotor (10, 21) of said electric machine (3, 20) and vice versa, comprise a rigid linkage between said motor shaft (6) and said rotor (10, 21), the case (8, 22) of said electric machine (3, 20) being rigidly linked to the structure (4) of said endothermic engine or electric motor (2).

2. Dynamic test bench, according to claim 1, **characterized in that** said rotor (10, 21) of said electric machine (3, 20) is rigidly linked to the flywheel (7) of said engine/motor (2).

3. Dynamic test bench, according to claim 1, **characterized in that** said rigid linkage between the structure (4) of said engine/motor (2) and said case (8, 22) of said electric machine (3, 20) is made using the fixing holes and datum-pins (5), obtained on said structure (4) to link said engine/motor (2) with the transmission system.

4. Dynamic test bench, according to any of the claims 1 to 3, **characterized in that** said electric machine, which generates motor and braking torque, is a synchronous electric machine (3).

5. Dynamic test bench, according to claim 4, **characterized in that** said rotor (10) of said synchronous electric machine (3) has the shape of a ring, or drum, (10a) integral to a disc (10b), said drum (10a) and said disc (10b) being coaxial with each other and with the stator (9) of said synchronous electric machine (3), said drum (10a) of said rotor (10) housing on its inner surface some permanent magnets (11) which are interfaced to said stator (9).

6. Dynamic test bench, according to claim 5, **characterized in that** the structure of the rotor (10) of said synchronous electric machine (3) is made of a non-ferrous material.

7. Dynamic test bench, according to claim 6, **characterized in that** said non-ferrous material is a composite material.

8. Dynamic test bed, according to claim 7, **characterized in that** said composite material is carbon fibre based.

9. Dynamic test bench, according to claim 6, **characterized in that** said non-ferrous material is an aluminium or titanium alloy.

10. Dynamic test bench, according to any of the claims 1 to 3, **characterized in that** said electric machine, motor and torque generator, is an asynchronous electric machine (20).
